Europäisches Patentamt

European Patent Office

Office européen des brevets

(11) Numéro de publication: **0 469 505 A2**

# DEMANDE DE BREVET EUROPEEN

(21) Numéro de dépôt: **91112695.1**

(22) Date de dépôt: **29.07.91**

(51) Int. Cl.5: **H01L 39/24**

(30) Priorité: **01.08.90 FR 9009849**

(43) Date de publication de la demande:
**05.02.92 Bulletin 92/06**

(84) Etats contractants désignés:
**AT BE CH DE DK ES FR GB GR IT LI LU NL SE**

(71) Demandeur: **GEC ALSTHOM SA**
**38, avenue Kléber**
**F-75116 Paris(FR)**

(72) Inventeur: **Dubots, Patrick**
**1, Chemin de Gaillarbois**
**F-78640 Neauphle le Chateau(FR)**
Inventeur: **Verhaege, Thierry**
**22, Allée Georges Brassens**
**F-91160 Saulx les Chartreux(FR)**

(74) Mandataire: **Weinmiller, Jürgen et al**
**Lennéstrasse 9 Postfach 24**
**W-8133 Feldafing(DE)**

(54) Matériau supraconducteur présentant des sites d'ancrage des vortex et procédé de fabrication d'un tel matériau.

(57) Matériau supraconducteur constitué d'un alliage supraconducteur présentant des sites d'ancrage des vortex, caractérisé par le fait que lesdits sites d'ancrage des vortex sont dus à la dispersion dans ledit alliage supraconducteur de grains d'un oxyde, d'un carbure ou d'un nitrure, ayant une résistivité électrique élevée, stable et inerte chimiquement vis-à-vis des constituants dudit alliage, lesdits grains ayant une dimension inférieure à $0,1\mu m$ et se trouvant dans une proportion inférieure à 10% en volume.

EP 0 469 505 A2

La présente invention concerne un matériau supraconducteur présentant des sites d'ancrage des vortex, ainsi qu'un procédé de fabrication d'un tel matériau.

On sait que l'obtention de densités de courant élevées dans les matériaux supraconducteurs suppose l'existence au sein de ces matériaux d'une fine structure de "défauts", ou sites d'ancrage des vortex. Pour être efficaces, ces sites d'ancrage doivent avoir des dimensions de l'ordre de $10^{-9}$ à $10^{-8}$ m, être nombreux, uniformément répartis, et présenter des propriétés électriques aussi différentes que possible de celles de leur voisinage.

On connaît actuellement deux procédés permettant de créer des sites d'ancrage des vortex dans un alliage supraconducteur de niobium et de titane.

Le premier procédé connu consiste à précipiter dans l'alliage une phase riche en titane de type Ti$\alpha$, par traitements thermiques, morcellement et déformation de ces précipités par écrouissage. Les meilleurs résultats sont obtenus avec des traitements multiples de longue durée, par exemple trois traitements de 80 heures ; ils supposent un écrouissage important qui ne peut être réalisé que sur des brins supraconducteurs de petit diamètre. Ces traitements thermiques très coûteux créent des phénomènes de diffusion qui nuisent à la qualité du produit. En outre, on constate que les précipités ont des natures, des formes et des dimensions variées, prouvant qu'un tel procédé n'est pas optimisé.

Le second procédé connu consiste à préparer une structure ordonnée de défauts macroscopiques, et à la réduire à l'échelle microscopique par écrouissage. Ainsi par exemple, on perce des trous cylindriques dans un lopin d'alliage de niobium-titane, on les garnit de tiges en un matériau ductile et on effectue plusieurs étapes de transformation pour atteindre les dimensions requises : extrusion, étirage, tronçonnage, assemblage, nouvelle extrusion etc... La nécessité d'utiliser un matériau ductile limite les choix possibles et exclut en particulier la famille des oxydes ; les phénomènes de diffusion entre ce matériau et le niobium-titane peuvent compromettre la transformation du produit et/ou réduire l'efficacité des sites d'ancrage.

Une variante de ce second procédé est mise en oeuvre lorsque l'on fabrique des brins à filaments ultra-fins, les défauts souhaités étant alors constitués par les interfaces filaments-matrices. Dans ce cas particulier le coût de la transformation est justifié par la qualité du produit et notamment son faible niveau de pertes en régime alternatif.

La présente invention a pour but de mettre en oeuvre un matériau supraconducteur présentant des sites d'ancrage des vortex pouvant être obtenus avec des coûts et des délais de transformation considérablement réduits.

La présente invention a pour objet un matériau supraconducteur constitué d'un alliage supraconducteur présentant des sites d'ancrage des vortex, caractérisé par le fait

- que ledit alliage se compose
  - de niobium associé à au moins l'un des éléments choisis parmi le titane, l'étain, l'aluminium, le zirconium, l'hafnium, le tantale, le germanium
  - ou de vanadium associé à au moins l'un des éléments choisis parmi le gallium, le silicium, l'aluminium,
- et que lesdits sites d'ancrage des vortex sont dûs à la dispersion dans ledit alliage supraconducteur de grains d'un carbure, d'un nitrure ou d'un oxyde choisi parmi $TiO_2$, $Y_2O_3$, $Al_2O_3$, $Ta_2O_5$, MgO, $MnO_2$, ayant une résistivité électrique élevée, stable et inerte chimiquement vis-à-vis des constituants dudit alliage, lesdits grains ayant une dimension inférieure à 0,1 $\mu$m et se trouvant dans une proportion inférieure à 10 % en volume.

Ledit oxyde, carbure ou nitrure, présente une résistivité électrique supérieure à 100$\mu$ $\Omega$ .cm.

La présente invention a également pour objet un procédé de fabrication du matériau supraconducteur précédent. Selon ce procédé, on part d'une poudre fine dudit alliage, ou d'un mélange de poudres fines des précurseurs de cet alliage ; lesdits grains d'oxyde, de carbure ou de nitrure, sont ajoutés et l'ensemble est longuement broyé, puis compacté et extrudé à chaud.

La phase d'extrusion peut éventuellement être confondue avec la première phase de réalisation du conducteur supraconducteur.

Au cours du broyage les particules de poudre, qui sont ductiles, sont déformées, fragmentées et assez uniformément pigmentées par les grains d'oxyde, de carbure, ou de nitrure,dont la taille est encore susceptible de diminuer par fragmentation. Ces grains, qui sont fortement résistifs, constituent des sites d'ancrage supérieurs à ceux des matériaux antérieurs. Ils accroissent de plus la tenue mécanique de l'alliage, sans compromettre sa ductilité.

Le procédé selon l'invention peut être aisément optimisé par variation de la nature, de la taille et de la proportion des grains.

Le coût et le délai de transformation du procédé selon l'invention se trouvent considérablement réduits vis-à-vis des procédés antérieurs pour les raisons suivantes :

- la compaction aux cotes souhaitées évite les pertes d'usinage ;
- les traitements thermiques ne sont plus nécessaires ;
- la densité de courant critique est a priori indépendante de la taille des brins et des filaments, ainsi que du taux d'écrouissage : il en résulte certaines possibilités de standardisation ;

- un écrouissage important n'est pas nécessaire.

D'autres caractéristiques et avantages de la présente invention apparaîtront au cours de la description suivante d'un exemple de réalisation d'un matériau supraconducteur pigmenté par dispersion d'oxyde.

Des poudres fines de niobium et de titane, présentant une granulométrie de l'ordre de la dizaine de microns, sont mélangées dans la proportion de 53,5% en poids de niobium et 46,5% en poids de titane. On ajoute au mélange obtenu 5% en volume de poudre d'oxyde de titane $TiO_2$ de granulométrie très basse, inférieure à 1000 Å. L'ensemble est homogénéisé dans un broyeur qui assure l'incorporation des grains d'oxyde dans les particules métalliques. Ces opérations sont réalisées sous gaz neutre ou sous vide.

Le mélange obtenu est compacté isostatiquement, puis fritté sous vide à une température de 1100° C pendant 24 heures. Ce traitement est terminé par une trempe.

Le lopin fritté est ensuite introduit dans un tube de cuivre qui est scellé sous vide. Si l'alliage de niobium-titane est destiné à la réalisation de filaments de diamètre inférieur à 10 microns, un tube de niobium est placé entre le tube de cuivre et le lopin de niobium-titane. L'ensemble est extrudé à une température comprise entre 500 et 650° C. La barre extrudée constitue l'élément de base à la réalisation bien connue de brins supraconducteurs mono ou multifilamentaires.

Bien entendu l'invention n'est pas limitée au procédé de fabrication ni au matériau décrits. En particulier il existe un grand choix au niveau de l'alliage, de l'oxyde dispersé, et des proportions des différents éléments entrant dans la composition du matériau supraconducteur. En ce qui concerne les grains d'oxyde ajoutés, leur quantité dépend de l'induction magnétique à laquelle l'optimisation de la densité de courant critique est souhaitée. Plus cette induction est élevée, plus la quantité d'oxydes sera élevée, mais on ne dépassera pas 10% en volume pour maintenir la capacité de déformation de l'alliage.

## Revendications

1. Matériau supraconducteur constitué d'un alliage supraconducteur présentant des sites d'ancrage des vortex, caractérisé par le fait
   - que ledit alliage se compose
     - de niobium associé à au moins l'un des éléments choisis parmi le titane, l'étain, l'aluminium, le zirconium, l'hafnium, le tantale, le germanium
     - ou de vanadium associé à au moins l'un des éléments choisis parmi le gallium, le silicium, l'aluminium,
   - et que lesdits sites d'ancrage des vortex sont dûs à la dispersion dans ledit alliage supraconducteur de grains d'un carbure, d'un nitrure ou d'un oxyde choisi parmi $TiO_2$, $Y_2O_3$, $Al_2O_3$, $Ta_2O_5$, MgO, $MnO_2$, ayant une résistivité électrique élevée, stable et inerte chimiquement vis-à-vis des constituants dudit alliage, lesdits grains ayant une dimension inférieure à 0,1 $\mu$m et se trouvant dans une proportion inférieure à 10 % en volume.

2. Matériau supraconducteur selon la revendication 1, caractérisé par le fait que ledit oxyde, carbure ou nitrure, présente une résistivité électrique supérieure à $100\mu$ $\Omega$. cm.

3. Procédé de fabrication d'un matériau supraconducteur selon la revendication 1, dans lequel on part d'une poudre fine dudit alliage ou d'un mélange de poudres fines des précurseurs de cet alliage, procédé caractérisé par le fait que lesdits grains d'oxyde, de carbure ou du nitrure sont ajoutés à ladite poudre, ou audit mélange de poudres, que l'ensemble est longuement broyé, compacté et extrudé à chaud.

4. Procédé de fabrication selon la revendication 3, caractérisé par le fait que ladite poudre ou ledit mélange de poudres a une granulométrie de l'ordre de la dizaine de microns.